Europäisches Patentamt

(19) European Patent Office

Office européen des brevets

(11) Publication number: **0 111 635**
**A2**

# (12) EUROPEAN PATENT APPLICATION

(21) Application number: **83109118.6**

(22) Date of filing: **15.09.83**

(51) Int. Cl.³: **G 02 B 7/11**
**G 02 B 21/24**

(30) Priority: **20.12.82 US 451362**

(43) Date of publication of application:
**27.06.84 Bulletin 84/26**

(84) Designated Contracting States:
**DE FR GB IT**

(71) Applicant: **International Business Machines Corporation**
**Old Orchard Road**
**Armonk, N.Y. 10504(US)**

(72) Inventor: **Bosch, James Fred**
**37 Beech Court**
**Fishkill New York 12524(US)**

(74) Representative: **Gallois, Gérard**
**Compagnie IBM France Département de Propriété**
**Industrielle**
**F-06610 La Gaude(FR)**

(54) Method of selecting the optimum focusing adjustment for an optical instrument.

(57) The method for automatically focusing an optical instrument such as for example microscope or the like comprises the steps of selecting a clear object area within the field for analysis, varying the focus and measuring and recording the size of the clear object area image as a function of the focus adjustment and selecting that focus adjustment wherein the clear object area has a maximum image size as the position of optimum focus. The method may also be practised by selecting an opaque area and selecting the minimum image size as corresponding to the optimum focus position. It is also possible to have selection of a clear and of an opaque object area. This method could be applied for example to measurement with microscopes for control of photomasks used in semiconductor integrated circuits manufacture.

./...

IMAGE SIZE IN
MICROMETERS

5,95μm

5,90μm

5,85μm

5,80μm

FIG. I

5,91μm CLEAR IMAGE

-0,5 μm -0,4μm -0,3μm -0,2μm -0,1μm  0  + 0,1μm +0,2μm+ 0,3μm +0,4μm+ 0,5μm
(START)

OBJECTIVE TO OBJECT MOTION IN MICROMETERS

**0111635**

## METHOD OF SELECTING THE OPTIMUM FOCUSING
## ADJUSTMENT FOR AN OPTICAL INSTRUMENT

### Description

### Technical Field of the Invention

This invention relates generally to a method for automatically focusing an optical instrument such as for example microscope or the like and can be more particularly used for example in image measurement in photolithography.

### Background Art

Heretofore number of automatic methods and devices for focusing optical instrument have been proposed. It is well known that manually focusing an optical instrument leads to imprecision since it relies namely on the judgment of the operator which is essentially subjective and therefore depends on the individuals and the time or period of observation.

On the other hand the quality and accuracy of the optical instruments have so increased and the need for precision has become so great that an optimum focusing is absolutely necessary.

An example of the precision required from optical instruments is particularly found in the photolithographic processes used in manufacturing integrated circuits. For these processes masks are produced which selectively expose layers of light sensitive materials on semiconductor wafers. The dimensions of the discrete geometries or "images" of the masks are in the range of 1 to 20 μm.

For controlling the quality of these masks, it is necessary to measure these dimensions and then the precision of the measure will strongly depend on the correct focusing of the optical instrument such as a microscope used for the measurement.
The solutions found till now to the problem of the automatic focusing rely on different approaches.

The first one utilizes two dimensional scanner arrays. By use of an array of photosensors, such as, for example, a CCD array or a photodiode array, to dissect an image into points, it is possible to measure the intensity of the light passing through the optical instrument at the arrays of points.This data is then manipulated to obtain focus information.

Such a technique is disclosed, for example in U.S Patents 3,938,894, 4,005,443, 4,183,642 and 4,283,137.

U.S Patent 3,938,894 entitled "Focus Detecting Device" granted February 17, 1976 to Y. Nanba, shows a focus detecting device comprising first and second side-by-side longitudinally extending sets or groups of photoresponsive elements defining a checkered pattern. The detecting element is positioned in the focal plane of a lens and is either stationary or oscillated. The difference in potential between the diodes or the amplitude of the AC current in a circuit including the photodiodes is a function of the condition of focus of the lens.

U.S. Patent 4,005,443, entitled "Scanning Device and Method for Automatic Focusing" granted on January 25, 1977 to F. Abbrecht, discloses a device for automatically focusing an image wherein a photosensitive array with a plurality of discrete sites is positioned in the focal plane of the optical system. The illumination of the photosensitive array is dependent on the degree of focus of the image.

U.S. Patent 4,183,642, entitled "Automatic Focusing Devices" granted on January 15, 1980 to K. Fukuoka, describes also an automatic focusing device comprising means for deriving brightness data from a plurality of adjacent picture elements, handling these data to derive a value in fonction of which the focal point of the optical system will be adjusted.

U.S. Patent 4,283,137, entitled "Image Scanning System" granted on August 11, 1981 to T. Tsunekawa et al, shows an image scanning system in which an object image is electrically scanned by utilization of a photosensor array device and the image scanning output is quantized. Two different quantized image data, by the scanning output and by a predetermined voltage level are obtained.

The second approach which has been contemplated in the background art is the linear scan method. A detector scans across an image as the focus is varied. Focus is determined when a maximum of high frequency output is obtained, indicating the sharpest contrast. Examples of such a technique are given by U.S. Patent 3,918,071 and U.S. Patent 4,168,890.

U.S. Patent 3,918,071, entitled "Automatic Lens Focusing Method and Apparatus" granted on November 4, 1975 to F. ALbrecht, shows an automatic focusing method and apparatus wherein the object to be focused is projected on a screen while the adjustable lens is continuously moved through its focusing range. The image formed on the screen is scanned by a photoelectric device, the position of sharpest focus of the adjustable lens corresponding to a maximum of hight frequency components in the output of the photoelectric device.

U.S. Patent 4,168,890, entitled "Automatic Focusing Device" granted on September 25, 1979 to C.B. Fisher et al, discloses a similar device which comprises scanning means; the scanning current varies the focusing means automatically until the scanning current shows a maximum of high frequency component to low-frequency component power.

0111635

Some other techniques have been shown in the background art.

For example, U.S. Patent 3,211,831,entitled "Automatic Focus Control System and Method" granted on October 12, 1965 to W. L. Steiner, describes an autofocus control system and method which obtain and maintain optimum focus of an image utilizing the second derivative of the autocorrelation function of the image.

U.S. Patent 3,789,449, entitled "Atumatic Microscope Focusing Device" granted on March 19, 1974 to G. Reinheiner et al, discloses a microscope autofocus provided with an optical grating in the light path of the objective lens at a predetermined distance from the object to focus an image of an object portion.

U.S. Patent 4,025,785, entitled "Method of and Apparatus for the Automatic Focusing of Stereoscopic Microscopes" granted on May 24, 1977 to O. Mueller, shows a device for automatic focusing of a stereoscopic microscope utilizing rays focused on the object as small luminous areas and reflected back along the divided paths of the observations rays and directed on separate photoelectric detectors which convert axial shifts of the object plane into an electric signal which controls the focusing motor.

Also U.S. Patent 4,277,156, entitled "Focusing Position Detection Apparatus" granted on July 7, 1981 to Y. Fukushima et al, shows an improved focusing position apparatus utilizing a single photoelectric conversion element array divided in three portions disposed at different distances from an object, the signals from these portions being analyzed to detect the correct focus position.

All these different arts show that there exists a great number of solutions known in the technique for automatically focusing an optical instrument.

However to date none has shown a distinct advantage. The devices are rather complex, frequently using feedback servomechanisms. That complexity increases maintenance problems.

Moreover, the precision produced by the available autofocus mechanisms is around ± 0.5 μm which is not sufficient for the tolerances required in a number of the present technical fields, such as for example the manufacturing of integrated circuits.

It is therefore an object of the invention to provide a method for automatically focusing an optical instrument and more particularly a method for selecting the optimum focusing adjustement for an optical instrument, which is easy, precise and reliable.

## Summary of the Invention

The invention relates generally to a method for focusing an optical instrument such as, for example, a microscope or the like, having an object within its field of view with definitive clear and opaque areas.

The method of the invention could be implemented in different ways.

One implementation comprises the steps of :

(a) selecting a clear object area within the field for analysis,

(b) varying the focus and measuring and recording the size of the clear object area image as a function of the focus adjustment,

0111635

(c)   selecting that focus adjustment wherein the clear
object area has a maximum image size as the position
of optimum focus,

A second implementation of the method of the invention
comprises the steps of :

(a)   selecting an opaque object area within the field for
analysis,

(b)   varying the focus and measuring and recording the
size of the opaque object area image as a function of
the focus adjustment,

(c)   selecting that focus adjustment wherein the opaque
object area has a minimum image size as the position
of optimum focus.

The method of the invention could be further implemented by
mixing both implementations and selecting, when possible, a
clear object area and an opaque object area and selecting that
focus adjustment wherein the clear object area has a maximum
image size and the opaque object area has a minimum image size
as the position of optimum focus.

The method is based on the principle that the focus position
corresponds to a maximum of size for a clear object image and
to a minimum of size for an opaque object image.

The method can therefore be more generally formulated as
comprising the steps of :

(a)   selecting a delimited object area within the field
for analysis,

(b)   varying the focus and measuring and recording the
size of the object area image as a function of the
focus adjustment,

(c)   selecting that focus adjustment wherein the object area has an image size having an extremum as the position of optimum focus.

That method could be used with a number of optical instruments and in various technical fields.

An example of utilization of the method of the invention is for automatically focusing a microscope used for the control and manufacture of masks used in the manufacturing of integrated circuits.

The method of the present invention eliminates the primary factors of errors in the manual focusing methods which are the subjectivity of the operator judgment in the focusing operation and operator fatigue due to repeated observations.

The method of the invention presents the further advantage of giving a quick and precise focusing. The precision of focusing which could be reached is within $\pm$ 0,06 µm.

The method is moreover error free since it gives either the correct answer or no answer at all in case of errors in the measuring of the maximum or the minimum whereas operators of the known methods and systems may not detect any malfunction of the automatic focus positioning.

Other objects and features of the present invention will become apparent from the ensuing description taken in conjunction with the accompagnying drawings.

### Brief Description of the Drawings

A preferred embodiment of the present invention will hereinafter be described by reference to the accompanying drawings in which :

Fig. 1 is a representation of the curve resulting from the recording of the image size of the clear area in the field.

Fig. 2 is a representation of the curve resulting from the recording of the image size of the opaque area in the field.

Fig. 3 is another representation of the curve resulting from the recording of the image size of an other opaque area in the field.

Description of the Best Mode for Carrying out the Invention

The method of the invention as hereinabove stated can be utilized in many technical fields. For the ease of description it will be shown how the method of the invention is applied in the field of manufacturing of integrated circuits.

One of the fundamental operations in the manufacte of integrated circuits is the diffusion or implantation of impurities in semiconductor wafers.

These operations require the use of photomasks to selectively expose layers of light sensitive materials on the semiconductor wafers. These operations are generally designated as photolithographic processes.

The masks for these processes are generally composed of hundreds of thousands of discrete geometries or "images" in the range of 1 to 20 µm. As these images are generally repetitive a machine called "step-and-repeat" camera is generally used for the manufacturing of the masks. We wish to make of reference the article "The Step-and-Repeat Camera" by D.S. Alles and al. published in the Bell System Technical Journal, November 1970, pages 2145-2177 which shows the design and the control of such a "Step-and-Repeat" camera.

The manufacture and control of the masks imply the measurement of the dimensions and of the position of the discrete geometries or "images" which compose the masks.

This measurement is one of the most important parameters to be measured, controlled and assured. This directly affects device functionality and yield. As a typical mask or wafer may contain hundreds of thousands of images, this makes standard statistical techniques impractical. Present techniques involve the selection of typical images for measurement and control. It is essential that measurements taken on these control images be as accurate and precise as possible.

Generally for these measurements, optical microscopes are used. The accuracy of the measurement will depend primarily on the accuracy of the focus positionning of the microscope.

On photomasks product tolerances of ± 0,15 μm are common, with measurement tool precisions typically ± 0,04 μm. The primary contributing variable in these measurements is subjective operator, and operator to operator microscope focus. In fact the error comes mainly from the operator's eyesight limitations which make subjective his judgment of the correct focus position. To that can be added the error due to the fatigue inherent in repeated observations and the fact that under pressure to produce parts in the minimum amount of time, the operator is often not taking sufficient time to properly focus the equipment. This results in erroneous measurements without the operator knowing the error has been made.

As has been seen hereinabove, numerous autofocus mechanisms are known but are typically good to ± 0,5 μm with ± 0,25 μm goals in the future, which is not sufficiently satisfactory for the photomasks manufacturing and various other technical fields.

The method of the invention is based on the fact that with transmitted illumination, opaque images reach a minimum size value at best focus and clear images a maximum size value.

In the manufacture of semiconductor integrated circuits two types of photomasks are used called positive and negative where the geometries or "images" are opaque on a clear background and reciprocally are clear on a opaque background.

The method of the invention may be applied according to the type of photomasks observed to a clear object area or an opaque object area of the photomask.

We have seen that a typical mask or wafer may contain hundreds of thousands of images. Some small critical ones may be selected for measurement and control.

We suppose for example that the photomask is observed through a LEITZ orthoplan microscope using an 80X, 0.95 NA. (numerical aperture: objective, 25X eyepiece. Such a microscope is available from E. Leitz Inc, Rockleigh, New Jersey, 07647. The operator will select according to the type of masks observed the critical object area to measure and then will set an approximate focus and backoff.

According to the method of the invention, the focus will be varied and the size of the image will be measured and recorded as a function of the focus adjustment. As an example, with the microscope hereineabove cited a motor will drive the microscope through approximately 1 µm focus scan, that is ± 0,5 µm on each side of the operator focus adjustment. Indeed the range of scanning will depend on optics used.

The motor driving of the microscope may be realized by a 90 to 1 gear reduction box hooked to and vibrationally isolated from the microscope fine focus and driven by a SIGMA 292A-43

0111635

Uni-Polar R&L Driver with associated pulse generators and Power Supplies. Such a driver is available from SIGMA, 170 Pearl St, Braintree, MASS, 02184.

The focus adjustment will be generated by measuring objective to object height with a classical electronic gauge easily available on the market.

The measuring of the image size data could be implemented by using an ITP 158C currently available from I.T.P. Inc, 495 Mercury Drive, SUNNYVALE, Calif. 94086.

The measurement is realized, for example, by having the image to be measured highly magnified with an optical microscope set up for Koehler illumination. This highly magnified image is converted to an electrical signal by a closed circuit television system. The image measurement is accomplished by electrically measuring the time duration of the video signal of the desired image and electrically multiplying this time by a calibration factor to yield its size.

The data output from the measurement tool can be sent to a printer, a plotter or a data acquisition device such as for example a IBM 7406 Device Coupler. They may also be sent to a computer such as an IBM Series 1 or to any other data manipulation device capable of finding the minimum or maximum repeatable value.

The description of the implementation hereinabove shows how the method of the invention could be realized at low cost compared to the autofocus devices presently available.

The man skilled in the art will recognize that all components mentionned hereinabove are readily available and substitutable off-the-shelf types and may use to implement the method of the invention any of the other equivalent equipments, available on the market.

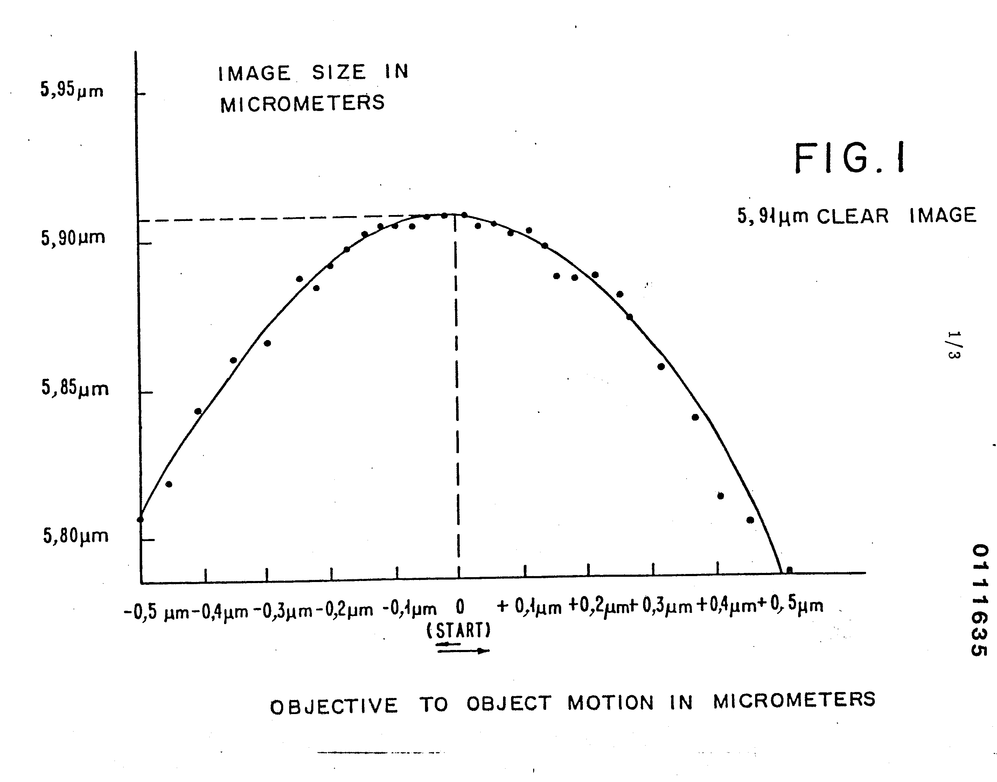

Refering to Figs. 1-3, it is shown results given by applying the method of the invention to typical photomasks.

In Fig. 1 the method has been applied by measuring the image size of a clear area when varying the objective to object distance on ± 0,5 µm on each side of the start position, set by the operator. It can be seen that the curve reaches a maximum for an image size of 5,91 µm and that the maximum corresponds to a focus position very near from the start position, at around 0,01 µm.

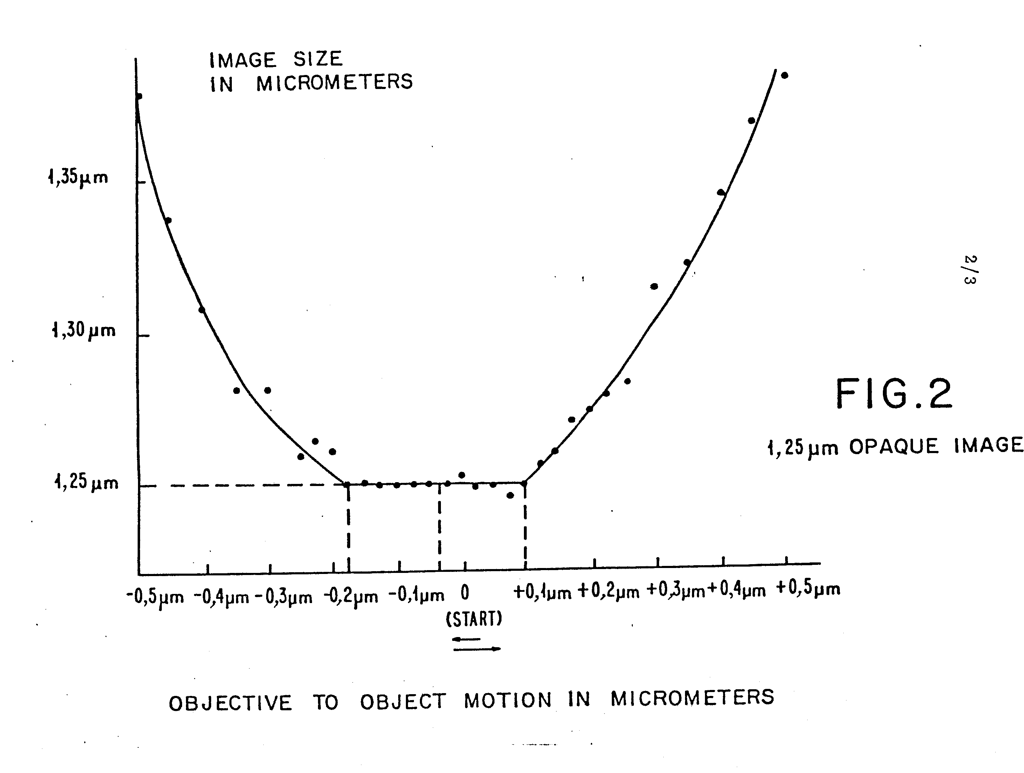

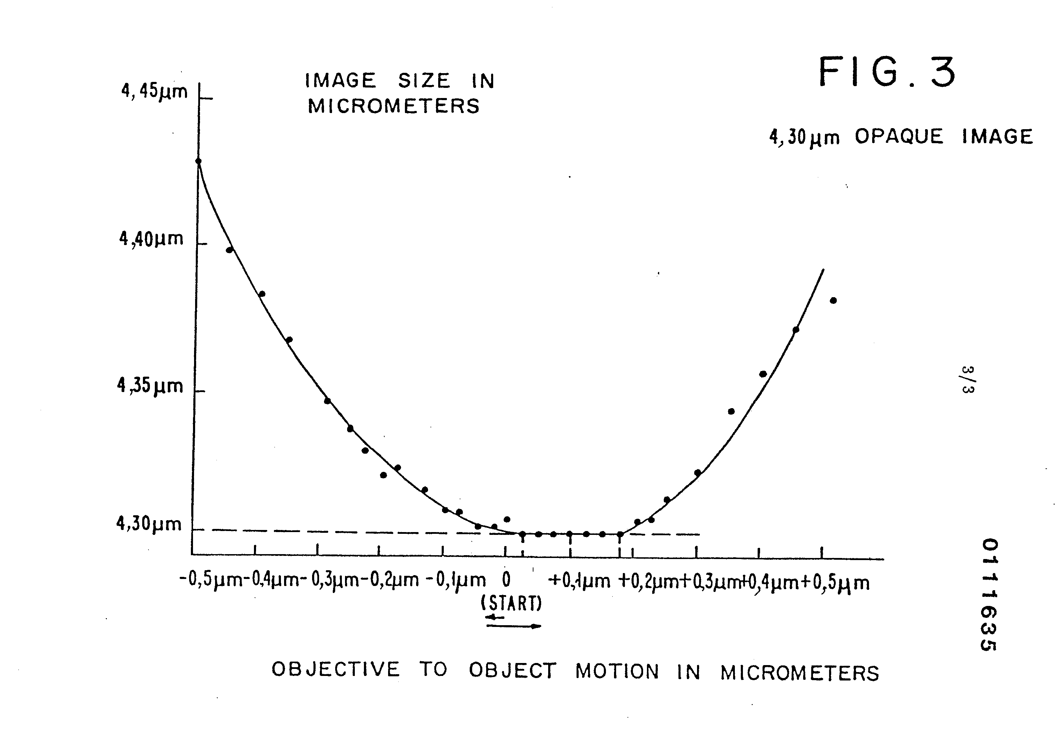

In Figs. 2 and 3 the method has been applied by measuring the image size of an opaque area.

In Fig. 2 the minimum of the curve is reached for an image size of 1,25 µm. However in that case the minimum does not correspond to a precise position of the objective, but the curve presents a flat portion. Consequently we would consider that the focus position is comprised between -0,18 µm and + 0,10 µm which correspond to the extremities of the flat portion. The best precision shall be obtained by taking as focus position the average value that is $\frac{1}{2}$ (-0,18 + 0,10) = -0,04 µm.

In Fig. 3 the opaque area is larger than for Fig. 2. The minimum of the image size is 4,30 µm. Again the minimum of the curve has a flat portion. The focus position is comprised between 0,03 µm and 0,18 µm.

The focus position may be taken as the average value which is 0,10 µm.

Figs. 1-3 show that the method of the invention applies as well with opaque image as with clear image and that there is no limitation to the dimensions of the opaque or clear area selected.

The man skilled in the art could easily understand that it is perfectly possible to apply the method of the invention several times to the same photomask with different areas selected. The precision of the determination of the focus position could be improved this way.

It may also happen that it could be formed on a same photomask opaque areas on a clear background and clear areas on an opaque background. In that case it is possible to mix the two aspects of the method of the invention by measuring the size of an opaque image and of a clear image and taking the minimum of the former and the maximum of the latter as focus position.

It would be also well understood by the man skilled in the art that the method of the invention could be applied to any type of optical instrument and not only to microscope, as long as it is possible to select a delimited clear or opaque area on the object observed.

The generality of the method of the invention implies that it could be utilized not only in the technical field of the photomasks manufacturing but also in any technical field where optical instruments are to be focused quickly and precisely.

CLAIMS

1.  Method of selecting the optimum focusing adjustment for an optical instrument having an object within its field of view characterized in that it comprises the steps of

    (a) selecting a delimited object area within the field for analysis,

    (b) varying the focus and measuring and recording the size of the object area image as a function of the focus adjustment,

    (c) selecting that focus adjustment wherein the object area has an image size having an extremum as the position of optimum focus.

2.  Method according to claim 1 characterized in that said delimited object area is clear and said extremum is a maximum.

3.  Method according to claim 1 characterized in that said delimited object area is opaque and said extremum is a minimum.

4.  Method according to claims 1 to 3 characterized in that it comprises the steps of

    (a) selecting a clear object area within the field of view for analysis,

    (b) varying the focus and measuring and recording the size of the clear image as a function of the focus adjustment,

    (c) selecting an opaque object area within the field of view for analysis,

    (d) varying the focus and measuring and recording the size of the opaque image as a function of the focus adjustment and

(e) selecting that focus adjustment wherein the clear object area has a maximum image size and the opaque object area has a minimum image size as the position of optimum focus.

5. Method according to anyone of claims 1 to 4 characterized in that said opticalinstrument is a microscope.

6. Method according to anyone of claims 1 to 5 characterized in that said object is a photomask.

FIG. I

IMAGE SIZE IN MICROMETERS

5,91μm CLEAR IMAGE

OBJECTIVE TO OBJECT MOTION IN MICROMETERS

1/3

0111635

IMAGE SIZE IN MICROMETERS

FIG.2

1,25 µm OPAQUE IMAGE

OBJECTIVE TO OBJECT MOTION IN MICROMETERS

0111635

FIG. 3